(19) **Europäisches Patentamt**

**European Patent Office**

**Office européen des brevets**

(11) **EP 1 179 255 B1**

(12) **EUROPÄISCHE PATENTSCHRIFT**

(45) Veröffentlichungstag und Bekanntmachung des Hinweises auf die Patenterteilung:
**12.04.2006   Patentblatt 2006/15**

(51) Int Cl.:
*H04L 27/36* (2006.01)       *H03F 1/32* (2006.01)
*H04L 27/26* (2006.01)

(21) Anmeldenummer: **00991091.0**

(86) Internationale Anmeldenummer:
**PCT/DE2000/004508**

(22) Anmeldetag: **16.12.2000**

(87) Internationale Veröffentlichungsnummer:
**WO 2001/048932 (05.07.2001 Gazette 2001/27)**

(54) **SENDER ZUM VERSENDEN VON SIGNALEN ÜBER FUNKKANÄLE UND VERFAHREN ZUM SENDEN VON SIGNALEN ÜBER FUNKKANÄLE**

TRANSMITTER FOR TRANSMITTING SIGNALS OVER RADIO CHANNELS AND METHOD FOR TRANSMITTING SIGNALS OVER RADIO CHANNELS

EMETTEUR POUR EMETTRE DES SIGNAUX SUR DES CANAUX RADIO ET PROCEDE POUR EMETTRE DES SIGNAUX SUR DES CANAUX RADIO

(84) Benannte Vertragsstaaten:
**DE FR GB IT**

(30) Priorität: **23.12.1999   DE 19962341**

(43) Veröffentlichungstag der Anmeldung:
**13.02.2002   Patentblatt 2002/07**

(73) Patentinhaber: **ROBERT BOSCH GMBH**
**70442 Stuttgart (DE)**

(72) Erfinder:
- **SCHRADER, Marc**
  **30161 Hannover (DE)**
- **LOCHAU, Mirko**
  **31134 Hildesheim (DE)**
- **HARMS, Lars**
  **31139 Hildesheim (DE)**
- **HENTATI, Nabil**
  **30165 Hannover (DE)**

(56) Entgegenhaltungen:
WO-A-00/60732          US-A- 5 598 436

- **RAPP C: "EFFECTS OF HPA-NONLINEARITY ON A 4-DPSK/OFDM-SIGNAL FOR A DIGITAL SOUND BROADCASTING SYSTEM" PROCEEDINGS OF THE 2ND EUROPEAN CONFERENCE ON SATELLITE COMMUNICATIONS, 22-10-91, LIEGE, Oktober 1991 (1991-10), XP000400752**
- **AMERICO BRAJAL ET AL: "COMPENSATION OF NONLINEAR DISTORTIONS FOR OTHOGONAL MULTICARRIER SCHEMES USING PREDISTORTION" PROCEEDINGS OF THE GLOBAL TELECOMMUNICATIONS CONFERENCE (GLOBECOM),US,NEW YORK, IEEE, 28. November 1994 (1994-11-28), Seiten 1909-1914, XP000488852 ISBN: 0-7803-1821-8**

**Beschreibung**

Stand der Technik

Die Erfindung geht aus von einem Sender zum Versenden von Signalen über Funkkanäle bzw. von einem Verfahren zum Senden von Signalen über Funkkanäle nach der Gattung der unabhängigen Patentansprüche.

Es ist bereits aus M. Schrader und N. Hentati "Reduktion von Außerbandstrahlung von Sendestufen im DAB-COFDM-System", OFDM Fachgespräche, September 1998, Braunschweig, abgedruckt im Konferenzband, bekannt, daß OFDM (Orthogonaler FrequenzMultiplex, engl. Orthogonal Frequency Division Multiplex) Signale vorverzerrt werden und zwar nach den Übertragungseigenschaften des Verstärkers im Sender. Dies ist notwendig, da die OFDM-Signale aufgrund des großen Unterschiedes zwischen den kleinen und den großen Amplituden, die in den OFDM-Signalen vorkommen, also der Dynamik oder Amplitudenvarianz, hohe Anforderungen an eine Linearität des Verstärkers im Sender stellen, weil alle Amplituden des OFDM-Signals linear verstärkt werden sollen. Es wurde in dem oben erwähnten Beitrag ein rückgekoppeltes System zur Vorverzerrung vorgeschlagen, bei dem ein Teil des verstärkten OFDM-Signals rückgekoppelt wird und mit einem gepufferten OFDM-Signal verglichen wird, um die Übertragungseigenschaften des Verstärkers im Sender zu bestimmen. Das gepufferte OFDM-Signal ist das OFDM-Signal, das dann verstärkt und rückgekoppelt wird. Da das OFDM-Signal einem Rauschsignal in seinen Eigenschaften sehr ähnlich ist, ist eine anspruchsvolle Synchronisation für das gepufferte OFDM-Signal und das verstärkte OFDM-Signal hier erforderlich.

Aus der älteren Patentanmeldung WO 00/60732 (veröffentlicht am 12.10.2000) ist es bereits bekannt, einen Piloten im Sender in den Hauptsignalpfad einzutasten, sodass dieses Pilotensignal die Aufwärtswandlung und Verstärkung mitmacht. Dadurch wird das Pilotensignal einer Kreuzmodulation und einer entsprechenden Verzerrung durch Nichtlinearitäten unterzogen. Mit diesem Pilotensignal ist damit eine Überwachung der Leistungsverstärker eines Senders möglich. Durch eine Regelschleife können die Verzerrungen im Sender minimiert werden. Aus US-A-5,598,436 ist ein digitales Übertragungssystem bekannt, bei dem OFDM verwendet wird. Dabei verursacht ein Verstärker Signalverzerrungen. Dafür weist das Übertragungssystem einen Vorverzerrer auf, um diese Verzerrung auszugleichen. Das System vermag in einem adaptiven Modus zu arbeiten.

Vorteile der Erfindung

Der erfindungsgemäße Sender zum Versenden von Signalen über Funkkanäle bzw. das erfindungsgemäße Verfahren zum Senden von Signalen über Funkkanäle mit den Merkmalen der unabhängigen Patentansprüche hat demgegenüber den Vorteil, daß ein Meßsignal in das OFDM-Signal eingetastet wird, um die Übertragungseigenschaften des Verstärkers zu bestimmen. Das hat den Vorteil, daß die kompletten Übertragungseigenschaften des Verstärkers ermittelt werden und damit eine bessere Vorverzerrung der OFDM-Signale ermöglicht wird.

Weiterhin ist von Vorteil, daß durch den Einsatz eines geeigneten Meßsignals eine einfachere und leichtere Synchronisation mit dem rückgekoppelten Meßsignal und einem gepufferten Meßsignal möglich wird.

Darüber hinaus ist es von Vorteil, daß das Meßsignal nur in vorgegebenen Zeitabschnitten eingetastet wird, wodurch eine Verschlechterung des gesendeten Signals durch die Eintastung minimiert wird.

Durch die in den abhängigen Ansprüchen aufgeführten Maßnahmen sind vorteilhafte Weiterbildungen und Verbesserungen des in den unabhängigen Patentansprüchen angegebenen Senders bzw. Verfahrens möglich.

Besonders vorteilhaft ist, daß als Modulationsverfahren für ein Aufprägen der Information auf die OFDM-Signale eine differentielle Phasenmodulation, vorzugsweise eine differentielle Quadraturphasenumtastung, eingesetzt wird. Dies hat den Vorteil, daß der Empfänger keine absolute Phase bestimmen muß, sondern allein die Phasenänderung zwischen den Signalen für eine Demodulation ermitteln muß.

Darüber hinaus ist von Vorteil, daß das Meßsignal eine von der Zeit unabhängige Einhüllende aufweist. Dadurch wird der Einfluß des Meßsignals auf die Messung selbst minimiert.

Es ist von Vorteil, daß die Amplitude des Meßsignals schrittweise erhöht wird, um die Übertragungseigenschaften des Verstärkers zu bestimmen. Dadurch wird eine Übertragungskennlinie des Verstärkers schrittweise ermittelt.

Darüber hinaus ist von Vorteil, daß das Meßsignal solch eine Amplitude aufweist, daß der Verstärker damit voll ausgesteuert wird. Dies spart bei der Ermittlung der Übertragungskennlinie Zeit und Bandbreite. Um dann die einzelnen Abschnitte der Übertragungskennlinie zu bestimmen, werden Abtastwerte dieses Meßsignals verwendet, um die Übertragungseigenschaften zu bestimmen.

Darüber hinaus ist von Vorteil, daß das Meßsignal in ein Synchronisationssymbol der Signale eingetastet wird, so daß keine Bandbreite für Nutzdaten verlorengeht.

Zeichnung

Ausführungsbeispiele der Erfindung sind in der Zeichnung dargestellt und in der nachfolgenden Beschreibung näher erläutert. Es zeigen Figur 1 ein Blockschaltbild eines erfindungsgemäßen OFDM-Senders, Figur 2 einen DAB-Rahmen und Figur 3 ein erfindungsgemäßes Verfahren zum Senden von Signalen über Funkkanäle.

Beschreibung der Ausführungsbeispiele

Orthogonaler Frequenzmultiplex (engl. Orthogonal Frequency Division Multiplex = OFDM) ist ein bekanntes und erfolgreiches Verfahren für mobile Funkanwendungen. Bei OFDM werden die zu versendenden Signale auf viele Unterträger verteilt, wobei diese Unterträger zueinander einen bestimmten Frequenzabstand haben, so daß sich die auf die Unterträger verteilten Signale gegenseitig nicht stören. Dieses Verhalten wird mit orthogonal beschrieben.

OFDM wird daher für digitale Rundfunkübertragungsverfahren eingesetzt, insbesondere für den mobilen Empfang, zum Beispiel mittels Autoradios. Dazu gehören DAB (Digital Audio Broadcasting), DVB (Digital Video Broadcasting) und DRM (Digital Radio Mondial). Diese Rundfunkübertragungsverfahren profitieren von der Eigenschaft von OFDM, daß, wenn eine frequenzselektive Dämpfung auftritt, nur ein geringer Teil des übertragenen Rundfunksignals gestört wird, da das Rundfunksignal auf eine Vielzahl von Frequenzen verteilt wurde und nur ein Signalanteil gestört wird, der auf einer Frequenz übertragen wird, bei der eine starke Dämpfung auftritt. Der gestörte Signalanteil wird durch fehlerdetektierende- und korrigierende Maßnahmen korrigiert. Zu diesen fehlerdetektierenden und -korrigierenden Maßnahmen gehören fehlerdetektierende und -korrigierende Codes wie z.B. Blockcodes oder Faltungscodes.

Bei OFDM tritt nach dem Verteilen der zu übertragenden Signale auf die Unterträger eine Summierung im Zeitbereich der verteilten Signale auf, wobei die Amplituden sich so addieren können, daß die Amplituden des überlagerten Signals zu bestimmten Zeitpunkten einmal einen sehr großen Wert annehmen und zum anderen einen sehr kleinen Wert annehmen. Dies hängt von der Phasenbeziehung der sich addierenden Signalanteile ab, ob sich die Signale konstruktiv oder destruktiv addieren. Ein Verstärker im Sender hat dabei die Aufgabe, alle Amplituden gleich zu verstärken, so daß keine nichtlinearen Verzerrungen auftreten.

Um die Übertragungseigenschaften des Verstärkers im Sender zu berücksichtigen, ist eine Vorverzerrung vorgesehen. Um eine Übertragungskennlinie des Verstärkers zu bestimmen, muß ein Signal, das von dem Verstärker verstärkt wurde, mit dem ursprünglichen Signal verglichen werden. Das OFDM-Signal ist aufgrund der unkorrelierten Folge von Amplituden, die durch die Addition der einzelnen Signalanteile auftritt, eine Herausforderung, da eine Synchronisation des ursprünglichen OFDM-Signals mit dem verstärkten OFDM-Signal schwierig ist.

Für die Verstärkung der OFDM-Signale soll der Verstärker nur im linearen Bereich betrieben werden. Wird ein Signal, das bei einer bestimmten Frequenz übertragen wird, auf eine nichtlineare Kennlinie gegeben, z.B. eben die des Verstärkers, entstehen Frequenzkomponenten bei Vielfachen dieser bestimmten Frequenz. Sind diese Vielfachen außerhalb des Sendefrequenzspektrums, spricht man von Außerbandstrahlung, da dann Signalenergie außerhalb des verfügbaren Spektrums übertragen wird und damit für die Signalübertragung verlorengeht, weil ein Empfänger die Außerbandstrahlung herausfiltert. Darüber hinaus stört die Außerbandstrahlung andere Übertragungssysteme die bei Frequenzen eingesetzt werden, bei denen die Außerbandstrahlung auftritt.

Sind neue Frequenzkomponenten innerhalb des zur Verfügung stehenden Sendefrequenzspektrums vorhanden, werden unerwünschte Signalkomponenten im Empfänger demoduliert. Es kommt also zu einem Nebensprechen. Dadurch wird die Signalqualität und damit die Bitfehlerrate des empfangenen Signals entscheidend verschlechtert. Die Bitfehlerrate gibt an, wie viele Bits pro empfangenen Bits falsch detektiert werden. Um die Bitfehlerrate zu bestimmen, werden die fehlerdetektierenden Codes verwendet. Das OFDM-Signal liegt also nach dem Verteilen der zu übertragenden Signale auf die Unterträger wie ein Rauschsignal vor, wobei einzelne Amplitudenspitzen den Verstärker des Senders in den nichtlinearen Bereich treiben können. Daher ist eine Vorverzerrung des OFDM-Signals notwendig, damit die Kennlinie des Verstärkers keinen Einfluß auf das Spektrum des OFDM-Signals nimmt.

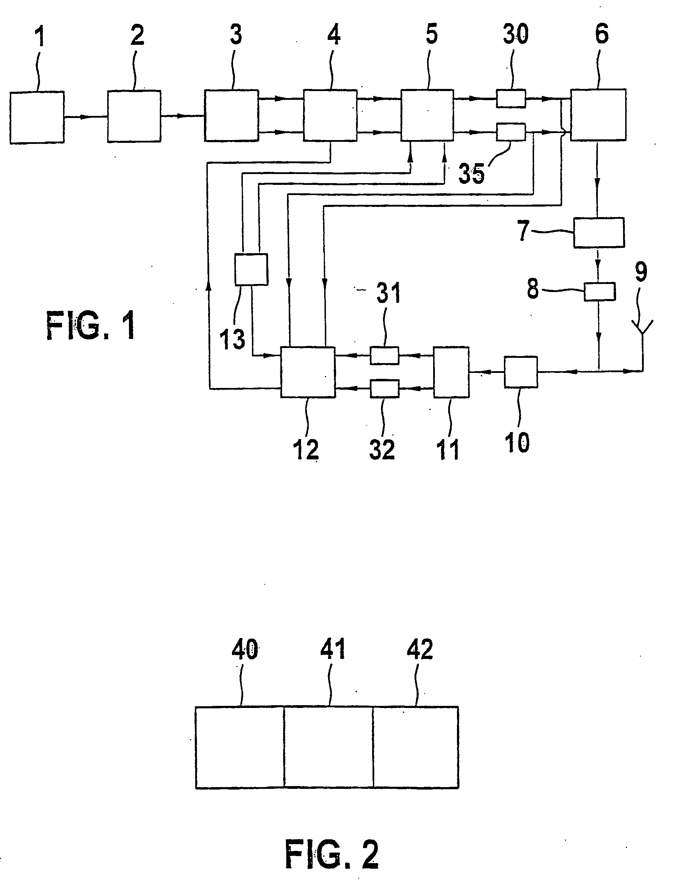

In Figur 1 ist ein Blockschaltbild eines erfindungsgemäßen OFDM-Senders dargestellt. Eine Datenquelle 1 dient hier zur Erzeugung der Daten. Die Datenquelle 1 ist hier ein Mikrophon mit angeschlossener Elektronik zur Verstärkung und Digitalisierung der vom Mikrophon gewandelten Sprachsignale. Das Mikrophon 1 wandelt Schallwellen in analoge elektrische Signale um, die von der an das Mikrophon angeschlossenen Elektronik verstärkt und digitalisiert werden. Der aus diesen Sprachsignalen entstandene digitale Datenstrom führt in eine Quellencodierung 2. Diese Quellencodierung 2 wird auf einem Prozessor durchgeführt.

Die Quellencodierung 2 reduziert die Zahl der Bits die aus den Sprachsignalen entstanden ist, indem die Quellencodierung 2 Redundanz aus dem digitalen Datenstrom entnimmt. Unter Ausnutzung von psychoakustischen Modellen werden aus den Sprachsignalen Daten eliminiert, die zur Wiedergabe der Sprachsignale nicht notwendig sind. Der durch die Quellencodierung 2 reduzierte Datenstrom wird dann auf einen OFDM-Modulator 3 gegeben. Im übrigen können neben Sprachsignalen auch andere Daten wie Text-, Bild- und Videodaten übertragen werden. Hier wird dann eine für die Art der Daten spezifische Quellencodierung vorgenommen.

Der OFDM-Modulator 3 führt zunächst eine differentielle Phasenmodulation der zu übertragenden Signale durch. Dazu wird die differentielle Quadraturphasenumtastung, die englisch als Differential Quadrature Phase Shift Keying (DQPSK) bezeichnet wird, verwendet. Die DQPSK ist eine digitale Modulation, bei der die Phasenänderung des Signals moduliert wird. Dabei wird die Phasenänderung in einem bestimmten Zeitabstand, also pro Bit, als Modulationssignal eingesetzt. Hier wird eine Phasenänderung von +/- 90° verwendet. Differentielle Modulationsverfahren haben den Vorteil, daß kein Absolutwert im Empfänger ermittelt werden muß, um die Signale zu demodulieren, da die übertragene Information in der Phasenänderung der übertragenen Signale enthalten ist. Eine Bitfolge von 110 führt also zu einer Phasenänderung von jeweils +90° für die beiden Einsen und -90° für die Null.

Neben der DQPSK können auch andere differentielle und nichtdifferentielle Phasenmodulationsverfahren angewendet werden. Es ist jedoch auch möglich, auch Amplitudenmodulationsverfahren oder Frequenzmodulationsverfahren hier einzusetzen.

Die DQPSK ist ein komplexes Modulationsverfahren, da die Bits des Bitstroms der in den OFDM-Modulator 3 geführt wird auf Phasenänderungen abgebildet werden. Wird eine Phase eines Signals verändert, benutzt man eine komplexe Ebene für die grafische Darstellung der Signale als Zeiger, wobei ein Realteil auf der Abszisse und ein Imaginärteil auf der Ordinate abgetragen wird. Ein Signal mit einer Phase von >0 wird, um diese Phase in der komplexen Ebene gegen den Uhrzeigersinn von der Abszisse aus gedreht. Führt man viermal eine Phasenänderung um 90° durch, ist man wieder bei dem Ausgangssignal. Es sind demnach vier von einander unterscheidbare Modulationszustände mit DQPSK möglich.

Neben der differentiellen QPSK führt der OFDM-Modulator 3 die Verteilung der zu demodulierenden Signale auf die Unterträger durch, so daß ein OFDM-Signal entsteht. Da als Folge der DQPSK, die der OFDM-Modulator 3 durchführt, ein komplexes Signal entsteht, ist ein erster und ein zweiter Datenausgang vom OFDM-Modulator 3 an einen ersten und zweiten Dateneingang eines Vorverzerrers 4 angeschlossen, um zwei Anteile des Signals Imaginär- und Realteil getrennt zu verarbeiten.

Der Vorverzerrer 4 verzerrt die von dem OFDM-Modulator 3 kommenden Signale gemäß einer Übertragungskennlinie des Verstärkers 8 vor. Die Übertragungskennlinie des Verstärkers gibt an, wie sich die Amplituden und die Phasen des Verstärkerausgangssignals als Funktion der Amplituden des Verstärkereingangssignals verändern. Der Vorverzerrer 4 invertiert diese Kennlinie, um die Vorverzerrung durchzuführen, wobei ein linearer Verstärkungsfaktor des Verstärkers 8 herausgerechnet wird, so daß die Vorverzerrung nicht zu einer Dämpfung der vom OFDM-Modulator 3 kommenden Signale führt. Der Vorverzerrer 4 ist auf einem digitalen Signalprozessor implementiert. Die Daten über die Kennlinie des Verstärkers 8 erhält der Vorverzerrer 4 über einen dritten Dateneingang von einem Meßmodul 12.

Die vorverzerrten Signale gelangen nach dem Vorverzerrer 4 in eine Eintastung 5. Die Signale sind nach wie vor komplex, so daß von dem Vorverzerrer 4 zwei Datenausgänge zu der Eintastung 5 führen. Die Eintastung 5 tastet ein Meßsignal in das vorverzerrte OFDM-Signal ein. Die Eintastung 5 schaltet demnach das Meßsignal in das OFDM-Signal zu bestimmten Zeitpunkten, so daß das Meßsignal anstatt des OFDM-Signals zu diesen Zeitpunkten vorliegt. Diese Zeitpunkte sind vorgegeben, zum Beispiel jede Stunde oder einmal pro Tag. Vor dem tatsächlichen Betrieb des erfindungsgemäßen Senders wird diese Messung durchgeführt und dann später zu den vorgegebenen Zeitpunkten während dem Betrieb des Senders fortgesetzt.

Bei DAB ist zu Beginn eines DAB-Rahmens mit dem die DAB-Signale übertragen werden, ein Nullsymbol zur Synchronisation vorgesehen. Figur 2 zeigt einen DAB-Rahmen. Ein Synchronisationskanal 40 zu Beginn des DAB-Rahmens weist das Nullsymbol auf. In einem sogenannten Fast Information Channel 41 werden Informationen über den Multiplex und andere Service-Informationen übertragen. Ein sogenannter Main-Service-Channel 42 weist die zu übertragenden Daten wie Audioprogramme und/oder Multimediadaten auf.

In dieses Nullsymbol wird das Meßsignal eingetastet, so daß keine anderen Daten, die im DAB-Rahmen übertragen werden, überschrieben werden. Es ist akzeptabel, daß ein Synchronisationssymbol das Nullsymbol eines DAB-Rahmens mit einem Meßsignal überschrieben wird, da nicht zu erwarten ist, daß die Synchronisation nach einem Rahmen bereits aussetzt, denn die Eintastung erfolgt, wie oben erwähnt, relativ selten. Das Meßsignal, das auch komplex ist, wird von einem Signalgenerator 13 erzeugt. Der Signalgenerator 13 weist zwei Datenausgänge auf, die zu der Eintastung 5 führen. Die Eintastung 5 erhält damit über seinen dritten und vierten Dateneingang das Meßsignal von dem Signalgenerator 13. Der Signalgenerator 13 ist ein allgemein üblicher Oszillator zur Erzeugung von Sinusschwingungen.

Das Meßsignal kann alternativ auch vor dem Vorverzerrer eingetastet werden. Weiter unten wird dieser Punkt erläutert.

Das Meßsignal hat folgende Anforderungen zu erfüllen: Zunächst darf das Meßsignal nicht von einem Baustein des Verstärkers gefiltert werden, daher wird für das Meßsignal eine sehr niedrige Frequenz verwendet. Darüber hinaus ist eine Bedingung, daß das Meßsignal eine konstante Einhüllende aufweist. Damit haben also die Amplituden eines Meßsignals den gleichen Wert, so daß die Einhüllende, die jeweils im positiven und negativen Bereich von Maximalwert zu Maximalwert gezogen wird, eine Parallele zur Abszisse ist, die die Zeitachse darstellt. Dadurch wird eine einfache Bestimmung des Übertragungsverhaltens des Verstärkers durch solch ein Meßsignal ermöglicht. Eine Sinusschwingung zeigt ein solches Verhalten.

Das OFDM-Signal mit dem eingetasteten Meßsignal geht über den ersten und zweiten Datenausgang als komplexes Signal von der Eintastung 5 zu jeweils einem Digital-Analogwandler 30 und 35, die die Anteile des komplexen Signals in analoge Signale umwandeln, die dann in einen Quadraturmodulator 6 gelangen. Mit dem Quadraturmodulator 6 wird das komplexe OFDM-Signal mit dem eingetasteten Meßsignal in ein reales Signal umgewandelt. Dabei wird das komplexe Signal y(t), das mathematisch mit

$$y(t) = a(t) + jb(t)$$

beschrieben wird, und durch folgende Vorschrift in ein reelles Signal x(t) umgewandelt:

$$x(t) = a(t)\cos(\omega t) - b(t)\sin(\omega t)$$

Dabei ist ω eine Frequenz, um die das OFDM-Signal durch eine Aufwärtsmischung in eine Zwischenfrequenz umgesetzt wird.

Nach dem Quadraturmodulator 6 folgt eben die Aufwärtsmischung 7, wobei nun das reelle OFDM-Signal in den Zwischenfrequenzbereich umgesetzt wird. Die Aufwärtsmischung 7 weist daher einen Oszillator auf, um die Frequenz zu erzeugen, um die das OFDM-Signal verschoben werden soll.

Das in die Zwischenfrequenz umgesetzte OFDM-Signal wird nach der Aufwärtsmischung 7 in den Verstärker 8 geführt oder entsprechend der Übertragungskennlinie des Verstärkers 8 verstärkt. Nach dem Verstärker 8 gelangen die OFDM-Signale einerseits zu einer Antenne 9, um damit versendet zu werden und andererseits zu einer Abwärtsmischung 10, die das verstärkte Signal wieder in ein Basisband herabsetzt. Dieser Anteil des OFDM-Signals wird also rückgekoppelt. Der Anteil ist natürlich im Vergleich zum versendeten Anteil sehr klein, zum Beispiel kleiner als ein Prozent, da die meiste Signalenergie zur Abstrahlung der OFDM-Signale verwendet wird. Die Auskopplung des rückgekoppelten OFDM-Signals erfolgt mit einem Richtkoppler. Der Richtkoppler weist zwei Leitungen auf, die so plaziert sind, daß eine elektromagnetische Auskopplung von Signalenergie von einer Leitung zur anderen Leitung ermöglicht wird.

Das Basisband ist der Frequenzbereich, in dem die Daten erzeugt wurden. Nach der Abwärtsmischung 10 wird in einem Quadraturdemodulator aus dem reellen Signal wieder ein komplexes Signal erzeugt, so daß der Quadraturmodulator 11 über zwei Datenausgänge verfügt, an die jeweils ein Analog-Digital-Wandler 31 und 32 angeschlossen ist, die die Anteile des komplexen Signals digitalisieren. Die digitalisierten Signale gelangen dann in das Meßmodul 12.

Das Meßmodul 12 erhält also über seinen ersten und zweiten Dateneingang das OFDM-Signal mit dem eingetasteten Meßsignal, das von dem Verstärker 8 verstärkt wurde. Über seinen dritten und vierten Dateneingang erhält das Meßmodul 12 von dem ersten und zweiten Datenausgang der Eintastung 5 das OFDM-Signal mit dem eingetasteten Meßsignal. Das OFDM-Signal mit dem eingetasteten Meßsignal, das von der Eintastung 5 zum Meßmodul 12 geführt wird, wird im Meßmodul 12 zwischengespeichert, bis das gleiche OFDM-Signal mit dem eingetasteten Meßsignal von dem Quadraturdemodulator 11 zum Meßmodul 12 gesendet wird. Damit wird ein Vergleich des eingetasteten Meßsignals vor und nach dem Verstärker 8 möglich. Durch den Vergleich nach Betrag und Phase in Abhängigkeit von den Eingangsamplituden wird die Übertragungskennlinie des Verstärkers 8 bestimmt. Um die Synchronisation durchzuführen, ist das Meßmodul 12 über seinen fünften Dateneingang mit einem dritten Datenausgang des Signalgenerators 13 verbunden, so daß das Meßmodul 12 darüber informiert wird, wann ein Meßsignal erzeugt wird. Das Meßmodul 12 weist einen Datenausgang auf, der mit einem zweiten Dateneingang des Vorverzerrers 4 verbunden ist, so daß der Vorverzerrer 4 gemäß der übermittelten Übertragungskennlinie des Verstärkers 8 die von dem OFDM-Modulator kommenden Signale vorverzerrt. Das Meßmodul 12 arbeitet nur, wenn ein Meßsignal eingetastet wird. Ein Prozessor steuert den Signalgenerator 13, wann das Meßsignal erzeugt wird.

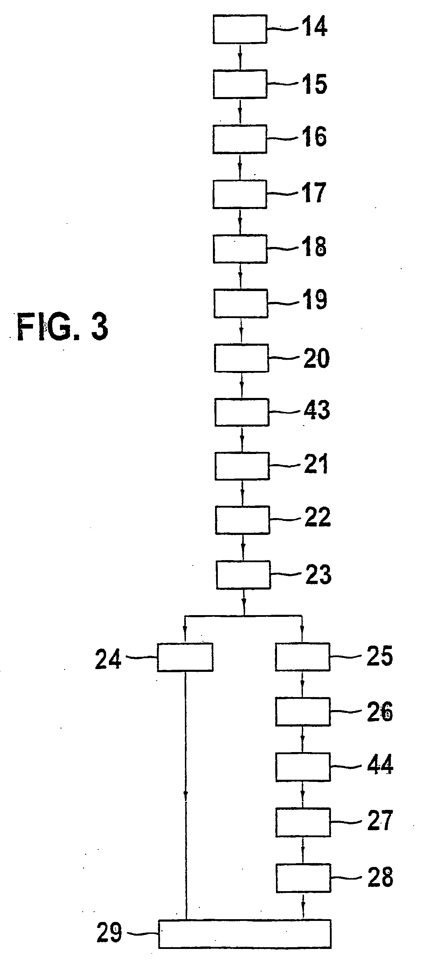

In Figur 3 ist ein erfindungsgemäßes Verfahren zum Senden von Signalen über Funkkanäle dargestellt. In Verfahrensschritt 14 werden die Daten erzeugt. Dies geschieht mittels eines Mikrophons, wie es oben beschrieben wurde. Aber auch andere Datenquellen sind möglich, wozu zum Beispiel ein Computer mit einer Tastatur gehört. In Verfahrensschritt 15 wird eine Quellencodierung durchgeführt, wobei von den Sprachsignalen Redundanz genommen wird, die für eine Rekonstruktion der Sprachdaten im Empfänger nicht notwendig sind. In Verfahrensschritt 16 wird eine Modulation des Datenstroms nach der Quellencodierung 15 durchgeführt, wobei hier eine, wie oben beschrieben wurde, differentielle Phasenmodulation durchgeführt wird.

In Verfahrensschritt 17 wird mittels einer OFDM-Modulation der Datenstrom auf verschiedene Unterträger verteilt. In Verfahrensschritt 18 wird eine Vorverzerrung gemäß der Übertragungskennlinie des Verstärkers 8 vorgenommen. In Verfahrensschritt 19 wird ein Meßsignal erzeugt. In Verfahrensschritt 20 wird das Meßsignal in das vorverzerrte OFDM-Signal zu bestimmten Zeitpunkten eingetastet und zwar an der Stelle des Nullsymbols. In Verfahrensschritt 43 wird eine Digital-Analog-Wandlung des OFDM-Signals mit dem Meßsignal vorgenommen. In Verfahrensschritt 21 wird eine Quadraturmodulation durchgeführt, um aus dem komplexen Signal ein reelles Signal herzustellen.

In Verfahrensschritt 22 wird das reelle Signal in die Zwischenfrequenz umgesetzt. In Verfahrensschritt 23 wird mittels des Verstärkers 8 eine Verstärkung des umgesetzten Signals vorgenommen. In Verfahrensschritt 24 wird das verstärkte Signal versendet, während ein Teil des verstärkten Signals in Verfahrensschritt 25 wieder abwärts gemischt wird und mit einem Quadraturdemodulator in Verfahrensschritt 26 in ein komplexes Signal wieder umgewandelt wird. In Verfahrensschritt 44 wird eine Analog-Digital-Wandlung des komplexen Signals vorgenommen, um in Verfahrensschritt 27 einen Vergleich mit dem gleichen Meßsignal, das eingetastet wurde und dem Meßsignal, das über den Verstärker 8 gegangen ist, durchzuführen, um die Übertragungskennlinie des Verstärkers 8 zu ermitteln. Wird kein Meßsignal eingetastet, endet hier das Verfahren. In Verfahrensschritt 28 wird der Vorverzerrer entsprechend der ermittelten Übertragungskennlinie des Verstärkers 8 eingestellt. In Verfahrensschritt 29 endet das Verfahren.

Das Meßsignal, das in verschiedene DAB-Rahmen eingetastet wird, wird in seiner Amplitude schrittweise erhöht, um die Kennlinie des Verstärkers 8 voll durchzufahren. Damit wird die gesamte Übertragungskennlinie des Verstärkers 8 ermittelt.

Alternativ wird ein Meßsignal mit einer nicht konstanten Einhüllenden in das OFDM-Signal eingetastet. Die Einhüllende des Meßsignals wird so eingestellt, daß der Verstärker 8 voll ausgesteuert wird. Durch Abtastwerte dieses Meßsignals wird die Übertragungskennlinie des Verstärkers 8 bestimmt.

In einer Alternative kann das Meßsignal vor dem Vorverzerrer 4 eingetastet werden, wobei dann der Vorverzerrer 4 mit konstanten Werten geladen wird, so daß der Vorverzerrer 4 dann einen bekannten Einfluß auf das Signal ausübt, der herausgerechnet werden kann. Idealerweise verändert der Vorverzerrer 4 dann das Signal nicht.

**Patentansprüche**

**Patentansprüche für folgende(n) Vertragsstaat(en): GB, IT**

1. Sender zum Versenden von Signalen über Funkkanäle, wobei ein Modulator (3) vorgesehen ist, der eine Modulation an den zu versendenden Signalen durchführt und die modulierten Signale auf verschiedene Unterträger verteilt, wobei ein Vorverzerrer (4) vorgesehen ist, der die auf verschiedene Unterträger verteilten Signale gemäß den Übertragungseigenschaften eines Verstärkers (8) vorverzerrt, wobei ein Mischer (7) vorgesehen ist, der die vorverzerrten Signale von einem Basisband in eine Zwischenfrequenz umsetzt, wobei der Verstärker (8) derart konfiguriert ist, dass der Verstärker (8) die umgesetzten Signale verstärkt, wobei eine Antenne (9) vorgesehen ist, die einen ersten Teil der verstärkten Signale versendet, wobei ein Mischer (10) vorgesehen ist, der einen zweiten Teil der verstärkten Signale von der Zwischenfrequenz in das Basisband heruntermischt, wobei ein Messmodul (12) vorgesehen ist, das die heruntergemischten Signale mit den vorverzerrten Signalen vergleicht, um die Übertragungseigenschaften des Verstärkers (8) zu ermitteln und dem Vorverzerrer (4) die Übertragungseigenschaften des Verstärkers (8) mitteilt, **dadurch gekennzeichnet, dass** ein Signalgenerator (13) vorgesehen ist, der ein Messsignal erzeugt, dass eine Eintastung (5) vorgesehen ist, die das Messsignal in die Signale zu vorgegebenen Zeitpunkten eintastet und dass das Messmodul (12) derart konfiguriert ist, dass das Messmodul (12) das Messsignal in den heruntergemischten Signalen mit dem Messsignal in den Signalen vergleicht, um die Übertragungseigenschaften des Verstärkers (8) zu erhalten.

2. Sender nach Anspruch 1, **dadurch gekennzeichnet, dass** die Eintastung (5) derart konfiguriert ist, dass die Eintastung (5) das Messsignal in die vorverzerrten Signale zu vorgegebenen Zeitpunkten eintastet und dass das Messmodul (12) derart konfiguriert ist, dass das Messmodul (12) das Messsignal in den heruntergemischten Signalen mit dem Messsignal in den vorverzerrten Signalen vergleicht, um die Übertragungseigenschaften des Verstärkers (8) zu ermitteln.

3. Sender nach Anspruch 1, **dadurch gekennzeichnet, dass** die Eintastung (5) derart konfiguriert ist, dass die Eintastung (5) das Messsignal vor dem Vorverzerrer (4) eintastet, wobei der Vorverzerrer (4) dabei mit einem Satz von konstanten Werten geladen wird.

4. Sender nach Anspruch 1, **dadurch gekennzeichnet, dass** der Modulator (3) derart konfiguriert ist, dass der Modulator (3) eine differentielle Phasenmodulation, vorzugsweise eine differentielle Quadraturphasenumtastung, durchführt.

5. Sender nach Anspruch 1, **dadurch gekennzeichnet, dass** der Signalgenerator (13) derart konfiguriert ist, dass der Signalgenerator (13) das Messsignal mit einer von der Zeit unabhängigen Einhüllenden erzeugt.

6. Verfahren zum Senden von Signalen über Funkkanäle, wobei die zu versendenden Signale moduliert werden, wobei die modulierten Signale auf Unterträger verteilt werden, wobei die auf die Unterträger verteilten Signale gemäß den Übertragungseigenschaften eines Verstärkers (8) vorverzerrt werden, wobei die vorverzerrten Signale von einem Basisband in eine Zwischenfrequenz umgesetzt werden, wobei die umgesetzten Signale verstärkt werden, wobei ein erster Teil der verstärkten Signale über die Funkkanäle versendet wird, wobei ein zweiter Teil der verstärkten Signale von einer Zwischenfrequenz in das Basisband umgesetzt wird, wobei die vorverzerrten Signale und die in das Basisband umgesetzten Signale verglichen werden, um die Übertragungseigenschaften des Verstärkers (8) zu ermitteln und dann einem Vorverzerrer (4) mitzuteilen, **dadurch gekennzeichnet, dass** Messsignale erzeugt werden, dass die Messsignale in die Signale zu vorgegebenen Zeitpunkten eingetastet werden und dass das Messsignal in den Signalen mit dem Messsignal der verstärkten und in das Basisband umgesetzten Signale verglichen wird, um die Übertragungseigenschaften des Verstärkers (8) zu ermitteln.

7. Verfahren nach Anspruch 6, **dadurch gekennzeichnet, dass** das Messsignal in die vorverzerrten Signale eingetastet wird.

8. Verfahren nach Anspruch 6, **dadurch gekennzeichnet, dass** das Messsignal vor dem Vorverzerrer (4) eingetastet wird, wobei der Vorverzerrer mit konstanten Werten geladen wird.

9. Verfahren nach Anspruch 6, **dadurch gekennzeichnet, dass** eine Amplitude des Messsignals schrittweise bis zu einer vorgegebenen Größe erhöht wird, um einen Aussteuerbereich des Verstärkers (8) zu messen.

10. Verfahren nach Anspruch 6, **dadurch gekennzeichnet, dass** die Amplitude des Messsignals eine Größe aufweist, so dass der Verstärker (8) durch das Messsignal mindestens voll ausgesteuert wird.

11. Verfahren nach Anspruch 10, **dadurch gekennzeichnet, dass** Abtastwerte des Messsignals zur Bestimmung der Übertragungseigenschaften des Verstärkers (8) verwendet werden.

12. Verfahren nach Anspruch 9 oder 11, **dadurch gekennzeichnet, dass** das Messsignal in ein Synchronisationssymbol eingetastet wird.

**Patentansprüche für folgende(n) Vertragsstaat(en): DE, FR**

1. Sender zum Versenden von Signalen über Funkkanäle, wobei ein Modulator (3) vorgesehen ist, der eine Modulation an den zu versendenden Signalen durchführt und die modulierten Signale auf verschiedene Unterträger verteilt, wobei ein Vorverzerrer (4) vorgesehen ist, der die auf verschiedene Unterträger verteilten Signale gemäß den Übertragungseigenschaften eines Verstärkers (8) vorverzerrt, wobei ein Mischer (7) vorgesehen ist, der die vorverzerrten Signale von einem Basisband in eine Zwischenfrequenz umsetzt, wobei der Verstärker (8) derart konfiguriert ist, dass der Verstärker (8) die umgesetzten Signale verstärkt, wobei eine Antenne (9) vorsehen ist, die einen ersten Teil der verstärkten Signale versendet, wobei ein Mischer (10) vorgesehen ist, der einen zweiten Teil der verstärkten Signale von der Zwischenfrequenz in das Basisband heruntermischt, wobei ein Messmodul (12) vorgesehen ist, das die heruntergemischten Signale mit den vorverzerrten Signalen vergleicht, um die Übertragungseigenschaften des Verstärkers (8) zu ermitteln und dem Vorverzerrer (4) die Übertragungseigenschaften des Verstärkers (8) mitteilt, wobei ein Signalgenerator (13) vorgesehen ist, der ein Messsignal erzeugt, wobei eine Eintastung (5) vorgesehen ist, die das Messsignal in die Signale zu vorgegebenen Zeitpunkten eintastet, wobei das Messmodul (12) derart konfiguriert ist, dass das Messmodul (12) das Messsignal in den heruntergemischten Signalen mit dem Messsignal in den Signalen vergleicht, um die Übertragungseigenschaften des Verstärkers (8) zu erhalten, wobei die Eintastung (5) derart konfiguriert ist, dass die Eintastung (5) das Messsignal in die vorverzerrten Signale zu vorgegebenen Zeitpunkten eintastet und wobei das Messmodul (12) derart konfiguriert ist, dass das Messmodul (12) das Messsignal in den heruntergemischten Signalen mit dem Messsignal in den vorverzerrten Signalen vergleicht, um die Übertragungseigenschaften des Verstärkers (8) zu ermitteln.

2. Sender nach Anspruch 1, **dadurch gekennzeichnet, dass** die Eintastung (5) derart konfiguriert ist, dass die Eintastung (5) das Messsignal vor dem Vorverzerrer (4) eintastet, wobei der Vorverzerrer (4) dabei mit einem Satz von konstanten Werten geladen wird.

3. Sender nach Anspruch 1, **dadurch gekennzeichnet, dass** der Modulator (3) derart konfiguriert ist, dass der Modulator (3) eine differentielle Phasenmodulation, vorzugsweise eine differentielle Quadraturphasenumtastung, durchführt.

4. Sender nach Anspruch 1, **dadurch gekennzeichnet, dass** der Signalgenerator (13) derart konfiguriert ist, dass der Signalgenerator (13) das Messsignal mit einer von der Zeit unabhängigen Einhüllenden erzeugt.

5. Verfahren zum Senden von Signalen über Funkkanäle, wobei die zu versendenden Signale moduliert werden, wobei die modulierten Signale auf Unterträger verteilt werden, wobei die auf die Unterträger verteilten Signale gemäss den Übertragungseigenschaften eines Verstärkers (8) vorverzerrt werden, wobei die vorverzerrten Signale von einem Basisband in eine Zwischenfrequenz umgesetzt werden, wobei die umgesetzten Signale verstärkt werden, wobei ein erster Teil der verstärkten Signale über die Funkkanäle versendet wird, wobei ein zweiter Teil der verstärkten Signale von einer Zwischenfrequenz in das Basisband umgesetzt wird, wobei die vorverzerrten Signale und die in das Basisband umgesetzten Signale verglichen werden, um die Übertragungseigenschaften des Verstärkers (8) zu ermitteln und dann einem Vorverzerrer (4) mitzuteilen, wobei Messsignale erzeugt werden, wobei die Messsignale in die Signale zu vorgegebenen Zeitpunkten eingetastet werden und wobei das Messsignal in den Signalen mit dem Messsignal der verstärkten und in das Basisband umgesetzten Signale verglichen wird, um die Übertragungseigenschaften des Verstärkers (8) zu ermitteln, wobei das Messsignal in die vorverzerrten Signale eingetastet wird.

6. Verfahren nach Anspruch 5, **dadurch gekennzeichnet, dass** das Messsignal vor dem Vorverzerrer (4) eingetastet wird, wobei der Vorverzerrer mit konstanten Werten geladen wird.

7. Verfahren nach Anspruch 5, **dadurch gekennzeichnet, dass** eine Amplitude des Messsignals schrittweise bis zu einer vorgegebenen Größe erhöht wird, um einen Aussteuerbereich des Verstärkers (8) zu messen.

8. Verfahren nach Anspruch 5, **dadurch gekennzeichnet, dass** die Amplitude des Messsignals eine Größe aufweist, so dass der Verstärker (8) durch das Messsignal mindestens voll ausgesteuert wird.

9. Verfahren nach Anspruch 8, **dadurch gekennzeichnet, dass** Abtastwerte des Messsignals zur Bestimmung der Übertragungseigenschaften des Verstärkers (8) verwendet werden.

10. Verfahren nach Anspruch 7 oder 9, **dadurch gekennzeichnet, dass** das Messsignal in ein Synchronisationssymbol eingetastet wird.

## Claims

### Claims for the following Contracting State(s): GB, IT

1. Transmitter for transmission of signals via radio channels, with a modulator (3) being provided, which carries out a modulation process on the signals to be transmitted and distributes the modulated signals to various subcarriers, with a predistorter (4) being provided, which predistorts the signals distributed to the various subcarriers in accordance with the transmission characteristics of an amplifier (8), with a mixer (7) being provided, which converts the predistorted signals from baseband to an intermediate frequency, with the amplifier (8) being configured in such a way that the amplifier (8) amplifies the converted signals, with an antenna (9) being provided which transmits a first portion of the amplified signal, with a mixer (10) being provided which down-mixes a second portion of the amplified signal from the intermediate frequency to baseband, with a measurement module (12) being provided, which compares the down-mixed signals with the predistorted signals in order to determine the transmission characteristics of the amplifier (8), and signals the transmission characteristics of the amplifier (8) to the predistorter (4), **characterized in that** a signal generator (13) is provided, which produces a measurement signal which is intended for keying (5), and keys the measurement signal into the signals at predetermined times, and **in that** the measurement module (12) is configured in such a way that the measurement module (12) compares the measurement signal in the down-mixed signals with the measurement signal in the signals, in order to obtain the transmission characteristics of the amplifier (8).

2. Transmitter according to Claim 1, **characterized in that** the keying (5) is configured in such a way that the keying (5) keys the measurement signal into the predistorted signals at predetermined times, and **in that** the measurement module (12) is configured in such a way that the measurement module (12) compares the measurement signal in the down-mixed signals with the measurement signal in the predistorted signals, in order to determine the transmission characteristics of the amplifier (8).

3. Transmitter according to Claim 1, **characterized in that** the keying (5) is configured in such a way that the keying (5) keys the measurement signal upstream of the predistorter (4), with the predistorter (4) in this case being loaded with a set of constant values.

4. Transmitter according to Claim 1, **characterized in that** the modulator (3) is configured in such a way that the modulator (3) carries out differential phase modulation, preferably differential quadrature phase keying.

5. Transmitter according to Claim 1, **characterized in that** the signal generator (13) is configured in such a way that the signal generator (13) produces the measurement signal with an envelope which is independent of the time.

6. Method for transmission of signals via radio channels, with the signals to be transmitted being modulated, with the modulated signals being distributed to subcarriers, with the signals distributed to the subcarriers being predistorted in accordance with the transmission characteristics of an amplifier (8), with the predistorted signals being converted from baseband to an intermediate frequency, with the converter signals being amplified, with a first portion of the amplified signals being transmitted via the radio channels, with a second portion of the amplified signals being converted from an intermediate frequency to baseband, with the predistorted signals and the signals which have been converted to baseband being compared in order to determine the transmission characteristics of the amplifier (8), and then being signalled to a predistorter (4), **characterized in that** measurement signals are produced, **in that** the measurement signals are keyed into the signals at predetermined times, and **in that** the measurement signal in the signals is compared with the measurement signal of the amplified signals which have been converted to baseband, in order to determine the transmission characteristics of the amplifier (8).

7. Method according to Claim 6, **characterized in that** the measurement signal is keyed into the predistorted signals.

8. Method according to Claim 6, **characterized in that** the measurement signal is keyed in upstream of the predistorter (4), with the predistorter being loaded with constant values.

9. Method according to Claim 6, **characterized in that** the amplitude of the measurement signal is increased in steps up to a predetermined magnitude in order to measure the drive range of the amplifier (8).

10. Method according to Claim 6, **characterized in that** the amplitude of the measurement signal has a magnitude such that the amplifier (8) is at least fully driven by the measurement signal.

11. Method according to Claim 10, **characterized in that** sample values of the measurement signal are used for determination of the transmission characteristics of the amplifier (8).

12. Method according to Claim 9 or 11, **characterized in that** the measurement signal is keyed into a synchronization symbol.


**Claims for the following Contracting State(s): DE, FR**

1. Transmitter for transmission of signals via radio channels, with a modulator (3) being provided, which carries out a modulation process on the signals to be transmitted and distributes the modulated signals to various subcarriers, with a predistorter (4) being provided, which predistorts the signals distributed to the various subcarriers in accordance with the transmission characteristics of an amplifier (8), with a mixer (7) being provided, which converts the predistorted signals from baseband to an intermediate frequency, with the amplifier (8) being configured in such a way that the amplifier (8) amplifies the converted signals, with an antenna (9) being provided which transmits a first portion of the amplified signal, with a mixer (10) being provided which down-mixes a second portion of the amplified signal from the intermediate frequency to baseband, with a measurement module (12) being provided, which compares the down-mixed signals with the predistorted signals in order to determine the transmission characteristics of the amplifier (8), and signals the transmission characteristics of the amplifier (8) to the predistorter (4), **characterized in that** a signal generator (13) is provided, which produces a measurement signal with keying (5) being provided, and keying the measurement signal into the signals at predetermined times, and with the measurement module (12) being configured in such a way that the measurement module (12) compares the measurement signal in the down-mixed signals with the measurement signal in the signals, in order to obtain the transmission characteristics of the amplifier (8), with the keying (5) being configured in such a way that the keying (5) keys the measurement signal into the predistorted signals at predetermined times, and with the measurement module (12) being configured in such a way that the measurement module (12) compares the measurement signal in the down-mixed signals with the measurement signal in the predistorted signals, in order to determine the transmission characteristics of the amplifier (8).

2. Transmitter according to Claim 1, **characterized in that** the keying (5) is configured in such a way that the keying (5) keys the measurement signal upstream of the predistorter (4), with the predistorter (4) in this case being loaded with a set of constant values.

3. Transmitter according to Claim 1, **characterized in that** the modulator (3) is configured in such a way that the modulator (3) carries out differential phase modulation, preferably differential quadrature phase keying.

4. Transmitter according to Claim 1, **characterized in that** the signal generator (13) is configured in such a way that the signal generator (13) produces the measurement signal with an envelope which is independent of the time.

5. Method for transmission of signals via radio channels, with the signals to be transmitted being modulated, with the modulated signals being distributed to subcarriers, with the signals distributed to the subcarriers being predistorted in accordance with the transmission characteristics of an amplifier (8), with the predistorted signals being converted from baseband to an intermediate frequency, with the converter signals being amplified, with the first portion of the amplified signals being transmitted via the radio channels, with a second portion of the amplified signals being converted from an intermediate frequency to baseband, with the predistorted signals and the signals which have been converted to baseband being compared in order to determine the transmission characteristics of the amplifier (8), and then being signalled to a predistorter (4), with measurement signals being produced, with the measurement signals being keyed into the signals at predetermined times, and with the measurement signal in the signals being compared with the measurement signal of the amplified signals which have been converted to baseband, in order to determine the transmission characteristics of the amplifier (8), with the measurement signal being keyed into the predistorted signals.

6. Method according to Claim 5, **characterized in that** the measurement signal is keyed in upstream of the predistorter (4), with the predistorter being loaded with constant values.

7. Method according to Claim 5, **characterized in that** the amplitude of the measurement signal is increased in steps up to a predetermined magnitude in order to measure the drive range of the amplifier (8).

8. Method according to Claim 5, **characterized in that** the amplitude of the measurement signal has a magnitude such that the amplifier (8) is at least fully driven by the measurement signal.

9. Method according to Claim 8, **characterized in that** sample values of the measurement signal are used for determination of the transmission characteristics of the amplifier (8).

10. Method according to Claim 7 or 9, **characterized in that** the measurement signal is keyed into a synchronization symbol.

**Revendications**

**Revendications pour l'(les) Etat(s) contractant(s) suivant(s): GB, IT**

1. Emetteur pour émettre des signaux sur des canaux radio,
dans lequel
un modulateur (3) effectue une modulation sur les signaux à émettre et répartit les signaux modulés sur différentes sous-porteuses, un dispositif de prédistorsion (4) est prévu pour prédistordre les signaux répartis sur différentes sous-porteuses suivant les caractéristiques de transmission d'un amplificateur (8), un mélangeur (7) convertit les signaux prédistordus d'une bande de base en une fréquence intermédiaire, l'amplificateur (8) est configuré pour amplifier les signaux convertis, une antenne (9) émet une première partie des signaux amplifiés, un mélangeur (10) mélange vers le bas une deuxième partie des signaux amplifiés de la fréquence intermédiaire dans la bande de base, un module de mesure (12) compare les signaux mélangés vers le bas avec les signaux prédistordus pour déterminer les caractéristiques de transmission de l'amplificateur (8) et transmet les caractéristiques de transmission de l'amplificateur (8) au dispositif de prédistorsion (4), **caractérisé en ce qu'**
un générateur de signal (13) génère un signal de mesure, un dispositif d'introduction (5) insère le signal de mesure dans les signaux à des moments prédéterminés, le module de mesure (12) est configuré pour comparer le signal de mesure dans les signaux mélangés vers le bas avec le signal de mesure dans les signaux pour obtenir les caractéristiques de transmission de l'amplificateur (8.).

2. Emetteur selon la revendication 1,
**caractérisé en ce que**
le dispositif d'introduction (5) est configuré pour insérer le signal de mesure dans les signaux prédistordus à des moments prédéterminés, et le module de mesure (12) est configuré pour comparer le signal de mesure dans les signaux mélangés vers le bas avec le signal de mesure dans les signaux prédistordus pour déterminer les caractéristiques de transmission de l'amplificateur (8).

3. Emetteur selon la revendication 1,
**caractérisé en ce que**
le dispositif d'introduction (5) est configuré pour insérer le signal de mesure avant le dispositif de prédistorsion (4) qui à cet effet est chargé avec un jeu de valeurs constantes.

4. Emetteur selon la revendication 1,
**caractérisé en ce que**
le modulateur (3) est configuré pour insérer une modulation de phase différentielle, de préférence une opération déphasée en quadrature différentielle.

5. Emetteur selon la revendication 1,
**caractérisé en ce que**
le générateur de signal (13) est configuré pour générer le signal de mesure avec une enveloppante indépendante du temps.

6. Procédé d'émission de signaux sur des canaux radio,
selon lequel

les signaux à émettre sont modulés, les signaux modulés sont répartis sur des sous-porteuses, les signaux répartis sur les sous-porteuses sont prédistordus suivant les caractéristiques de transmission d'un amplificateur (8), les signaux prédistordus sont convertis d'une bande de base en une fréquence intermédiaire, les signaux convertis sont amplifiés, une première partie des signaux amplifiés est émise sur les canaux radio, une deuxième partie des signaux amplifiés est convertie d'une fréquence intermédiaire dans la bande de base, les signaux prédistordus et les signaux convertis dans la bande de base sont comparés pour déterminer les caractéristiques de transmission de l'amplificateur (8) puis les transmettre à un dispositif de prédistorsion (4), **caractérisé en ce que** des signaux de mesure sont générés, les signaux de mesure sont insérés dans les signaux à des moments prédéterminés, et le signal de mesure dans les signaux est comparé avec le signal de mesure des signaux amplifiés et convertis en une bande de base pour déterminer les caractéristiques de transmission de l'amplificateur (8).

7. Procédé selon la revendication 6, **caractérisé en ce que** le signal de mesure est inséré dans les signaux prédistordus.

8. Procédé selon la revendication 6, **caractérisé en ce que** le signal de mesure est inséré avant le dispositif de prédistorsion (4) qui à cet effet est chargé avec des valeurs constantes.

9. Procédé selon la revendication 6, **caractérisé en ce qu'** une amplitude du signal de mesure augmente progressivement jusqu'à une grandeur prédéterminée pour mesurer une plage de réglage de l'amplificateur (8).

10. Procédé selon la revendication 6, **caractérisé en ce que** l'amplitude du signal de mesure présente une grandeur permettant un réglage au moins complet de l'amplificateur (8) par le signal de mesure.

11. Procédé selon la revendication 10, **caractérisé en ce qu'** on utilise des valeurs de balayage du signal de mesure pour déterminer les caractéristiques de transmission de l'amplificateur (8).

12. Procédé selon la revendication 10 ou 11, **caractérisé en ce que** le signal de mesure est inséré dans un symbole de synchronisation.

**Revendications pour l'(les) Etat(s) contractant(s) suivant(s): DE, FR**

1. Emetteur pour émettre des signaux sur des canaux radio, dans lequel un modulateur (3) effectue une modulation sur les signaux à émettre et répartit les signaux modulés sur différentes sous-porteuses, un dispositif de prédistorsion (4) est prévu pour prédistordre les signaux répartis sur différentes sous-porteuses suivant les caractéristiques de transmission d'un amplificateur (8), un mélangeur (7) convertit les signaux prédistordus d'une bande de base en une fréquence intermédiaire, l'amplificateur (8) est configuré pour amplifier les signaux convertis, une antenne (9) émet une première partie des signaux amplifiés, un mélangeur (10) mélange vers le bas une deuxième partie des signaux amplifiés de la fréquence intermédiaire dans la bande de base, un module de mesure (12) compare les signaux mélangés vers le bas avec les signaux prédistordus pour déterminer les caractéristiques de transmission de l'amplificateur (8) et transmet les caractéristiques de transmission de l'amplificateur (8) au dispositif de prédistorsion (4), un générateur de signal (13) génère un signal de mesure, un dispositif d'introduction (5) insère le signal de mesure dans les signaux à des moments prédéterminés, le module de mesure (12) est configuré pour comparer le signal de mesure dans les signaux mélangés vers le bas avec le signal de mesure dans les signaux pour obtenir les caractéristiques de transmission de l'amplificateur (8), le dispositif d'introduction (5) est configuré pour insérer le signal de mesure dans les signaux prédistordus à des moments prédéterminés, et le module de mesure (12) est configuré pour comparer le signal de mesure dans les signaux mélangés vers le bas avec le signal de mesure dans les signaux prédistordus pour déterminer les caractéristiques de transmission de l'amplificateur (8).

2. Emetteur selon la revendication 1, **caractérisé en ce que** le dispositif d'introduction (5) est configuré pour insérer le signal de mesure avant le dispositif de prédistorsion (4) qui à cet effet est chargé avec un jeu de valeurs constantes.

3. Emetteur selon la revendication 1, **caractérisé en ce que** le modulateur (3) est configuré pour insérer une modulation de phase différentielle, de préférence une opération déphasée en quadrature différentielle.

4. Emetteur selon la revendication 1, **caractérisé en ce que** le générateur de signal (13) est configuré pour générer le signal de mesure avec une enveloppante indépendante du temps.

**5.** Procédé d'émission de signaux sur des canaux radio,

selon lequel

les signaux à émettre sont modulés, les signaux modulés sont répartis sur des sous-porteuses, les signaux répartis sur les sous-porteuses sont prédistordus suivant les caractéristiques de transmission d'un amplificateur (8), les signaux prédistordus sont convertis d'une bande de base en une fréquence intermédiaire, les signaux convertis sont amplifiés, une première partie des signaux amplifiés est émise sur les canaux radio, une deuxième partie des signaux amplifiés est convertie d'une fréquence intermédiaire en une bande de base, les signaux prédistordus et les signaux convertis en une bande de base sont comparés pour déterminer les caractéristiques de transmission d'un amplificateur (8) puis les transmettre à un dispositif de prédistorsion (4), des signaux de mesure sont générés, les signaux de mesure sont insérés dans les signaux à des moments prédéterminés, et le signal de mesure dans les signaux est comparé avec le signal de mesure des signaux amplifiés et convertis en une bande de base pour déterminer les caractéristiques de transmission de l'amplificateur (8), le signal de mesure étant inséré dans les signaux prédistordus.

**6.** Procédé selon la revendication 5,
**caractérisé en ce que**
le signal de mesure est inséré avant le dispositif de prédistorsion (4) qui à cet effet est chargé avec des valeurs constantes.

**7.** Procédé selon la revendication 5,
**caractérisé en ce qu'**
une amplitude du signal de mesure augmente progressivement jusqu'à une grandeur prédéterminée pour mesurer une plage de réglage de l'amplificateur (8).

**8.** Procédé selon la revendication 5,
**caractérisé en ce que**
l'amplitude du signal de mesure présente une grandeur permettant un réglage au moins complet de l'amplificateur (8) par le signal de mesure.

**9.** Procédé selon la revendication 8,
**caractérisé en ce qu'**
on utilise des valeurs de balayage du signal de mesure pour déterminer les caractéristiques de transmission de l'amplificateur (8).

**10.** Procédé selon la revendication 7 ou 9,
**caractérisé en ce que**
le signal de mesure est inséré dans un symbole de

synchronisation.

FIG. 1

FIG. 2

**FIG. 3**